(19) Europäisches Patentamt / European Patent Office / Office européen des brevets

(11) **EP 4 148 432 B1**

(12) **FASCICULE DE BREVET EUROPEEN**

(45) Date de publication et mention
de la délivrance du brevet:
**24.04.2024  Bulletin 2024/17**

(21) Numéro de dépôt: **22193099.3**

(22) Date de dépôt: **31.08.2022**

(51) Classification Internationale des Brevets (IPC):
**G01P 15/097** *(2006.01)*     **H03H 9/02** *(2006.01)*
**G01P 15/08** *(2006.01)*

(52) Classification Coopérative des Brevets (CPC):
**G01P 15/097; H03H 9/02362;** G01P 2015/0814;
G01P 2015/0851

(54) **CAPTEUR MICROELECTROMECANIQUE RESONANT AVEC MASSE DE DECOUPLAGE INTERPOSEE ENTRE RESONATEUR ET MASSE D'EPREUVE**

MIKROELEKTROMECHANISCHER RESONANZSENSOR MIT ENTKOPPLUNGSMASSE ZWISCHEN RESONATOR UND TESTMASSE

MICROELECTROMECHANICAL RESONANT SENSOR WITH DECOUPLING MASS INTERPOSED BETWEEEN RESONATOR AND PROOFMASS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:  **09.09.2021  FR 2109455**

(43) Date de publication de la demande:
**15.03.2023  Bulletin 2023/11**

(73) Titulaire: **Commissariat à l'énergie atomique et aux énergies alternatives
75015 Paris (FR)**

(72) Inventeurs:
• **SANSA PERNA, Marc
38054 GRENOBLE CEDEX 09 (FR)**
• **MIANI, Théo
38054 GRENOBLE CEDEX 09 (FR)**
• **VERDOT, Thierry
38054 GRENOBLE CEDEX 09 (FR)**

(74) Mandataire: **Brevalex
Tour Trinity
1 B Place de la Défense
92400 Courbevoie (FR)**

(56) Documents cités:
**CN-A- 110 780 089      US-A1- 2007 163 347
US-A1- 2015 226 762**

• **SHENG-SHIAN LI ET AL: "Bridged micromechanical filters", FREQUENCY CONTROL SYMPOSIUM AND EXPOSITION, 2004. PROCEEDINGS OF THE 2 004 IEEE INTERNATIONAL MONTREAL, CANADA 23-27 AUG. 2004, PISCATAWAY, NJ, USA,IEEE, 23 août 2004 (2004-08-23), pages 280-286, XP010784625, DOI: 10.1109/FREQ.2004.1418465 ISBN: 978-0-7803-8414-9**

## Description

## DOMAINE TECHNIQUE ET ÉTAT DE LA TECHNIQUE ANTÉRIEURE

La présente invention se rapporte à un capteur microélectromécanique résonant à fonctionnement amélioré.

Le document US2007163347 fait partie de l'état de l'art. Il divulgue un accéléromètre résonant différentiel comportant deux sous-systèmes résonants, chacun de ces sous-systèmes comportant une masse d'épreuve couplée à un résonateur. Le capteur résonant comprend aussi un système de découplage ayant deux masses de découplage et des ressorts, le système de découplage formant un filtre passe-bas mécanique entre les sous-systèmes résonants.

Un capteur résonant mesure une grandeur physique grâce à son effet sur un élément résonant ou résonateur. La fréquence propre ou fréquence de résonance du résonateur dépend de la valeur de la grandeur physique à mesurer.

Un accéléromètre résonant est un exemple d'un tel capteur. Un accéléromètre résonant est un exemple d'un capteur résonant comportant une masse suspendue à un support et mobile sous l'effet d'une accélération et au moins un résonateur suspendu entre le support et la masse. Le résonateur est par exemple formé par une poutre vibrante, i.e. une poutre mise en vibration à sa fréquence de résonance par des électrodes. Lorsque la masse se déplace sous l'effet d'une accélération, la poutre qui est mécaniquement solidaire de la masse est comprimée ou étirée, ce qui modifie sa raideur apparente en flexion, et par conséquent sa fréquence de résonance. La variation de sa fréquence de résonance est détectée, ce qui permet de remonter à la valeur de l'accélération. La poutre résonante est utilisée comme capteur de force.

Les accéléromètres fabriqués suivant la technologie MEMS&NEMS (Microelectromechanical systems & Nanoelectromechanical systems en terminologie anglo-saxonne) comportent une masse de dimensions micrométriques, i.e. ayant une empreinte de quelques 100 $\mu$m de côté à quelques mm de côté, par exemple formée par un carré de 1000 $\mu$m. L'épaisseur de la masse peut atteindre par exemple jusqu'à 700 $\mu$m due à l'épaisseur du substrat, et une ou des poutres résonantes ou résonateurs de dimensions nanométriques, désignés nanorésonateurs. Les nanorésonateurs sont des poutres dont les dimensions peuvent être les suivantes : une longueur de quelques $\mu$m à quelques dizaines de $\mu$m et une section nanométrique de quelques dizaines de nm à 1 $\mu$m de côté.

En miniaturisant les poutres par rapport à la masse, il est possible d'atteindre une sensibilité à l'accélération beaucoup plus importante que celle atteinte part des accéléromètres comportant une masse sismique et des poutres de taille micrométrique.

La fréquence de résonance des poutres nanométriques est de l'ordre de plusieurs MHz, et la fréquence de résonance du mode fondamental de la masse sismique qui est de taille micrométrique est de l'ordre du kHz ou de quelques kHz.

Cet écart considérable entre les fréquences de résonance de la masse sismique et du nanorésonateur pose un certain nombre de problèmes. De par ses dimensions, la masse sismique suspendue possède un nombre important de modes de résonance avec une densité de modes qui est croissante au fur et à mesure que l'ordre des modes augmente et que leur fréquence propre s'écarte de la fréquence du mode fondamental. Plus spécifiquement, une masse sismique avec un mode fondamental de l'ordre du kHz présente une densité importante de modes à la fréquence de résonance du nanorésonateur de l'ordre du MHz; par la suite nous appellerons « modes parasites » les modes de résonance de masse sismique suspendue autres que son mode fondamental. Les propriétés caractéristiques de ces modes (fréquence et déformée modale) varient généralement très peu en fonction de l'accélération. En revanche, la fréquence de résonance du nanorésonateur varie en fonction de l'accélération, et sera donc amenée à « balayer » une certaine gamme de fréquences pendant son fonctionnement; par la suite on appellera cette gamme de fréquences « plage de fréquences du nanorésonateur ». Par conséquent, pendant le fonctionnement du capteur, la fréquence de résonance du nanorésonateur croise celle d'un mode parasite, entrainant dans certains cas un phénomène de couplage des modes. En pratique, les deux modes de résonance vont interagir entre eux et l'information de l'accélération contenue dans la fréquence du nanorésonateur sera perdue. Le capteur peut alors être rendu « aveugle » dans certaines plages de fréquence, voire il peut en résulter un déverrouillage de l'électronique de lecture du nanorésonateur. L'électronique de lecture met généralement en oeuvre une boucle à phase asservie; lorsqu'un mode parasite croise le mode de résonance du résonateur, la boucle est déréglée.

Afin d'éviter que la fréquence de résonance du nanorésonateur croise la fréquence d'un des modes de la masse sismique, la plage de fréquence du nanorésonateur peut être limitée aux fréquences qui ne sont pas celles des modes parasites. Mais cela a pour conséquence de limiter la gamme d'accélérations mesurable, ce qui dégrade la gamme dynamique du capteur.

## EXPOSÉ DE L'INVENTION

C'est par conséquent un but de la présente invention d'offrir un capteur résonant ne présentant pas les inconvénients ci-dessus et présentant une gamme dynamique étendue.

Le but énoncé ci-dessus est atteint par un capteur résonant comportant un corps d'épreuve mobile et au moins un résonateur disposés l'un par rapport à l'autre de sorte que le déplacement du corps d'épreuve provoque une variation de la contrainte dans le résonateur, ledit capteur comportant également des moyens de découplage mécanique entre le corps d'épreuve et le résonateur de sorte que le mouvement du résonateur à sa fréquence de résonance dans sa plaque de fréquence de l'ordre du MHz ou de quelques MHz ne puissent pas actionner les modes parasites du corps d'épreuve. Ainsi on évite que la fréquence de résonance du résonateur croise la fréquence d'un des modes de la masse sismique.

En d'autres termes on empêche le couplage entre les modes de résonance du résonateur et les modes parasites du corps d'épreuve. Les moyens de découplage ont une fonction de filtre passe-bas qui autorise la transmission des efforts basses fréquences de l'ordre du kHz ou de quelques kHz du corps d'épreuve vers le résonateur et empêche la transmission des efforts à haute fréquence de l'ordre du MHz ou de quelques MHz du résonateur vers le corps d'épreuve.

Le mouvement du résonateur ne peut alors pas actionner les modes parasites. En outre si les modes parasites étaient excités par un autre effet, comme par exemple une vibration à sa fréquence de résonance ou bien un choc, cette excitation n'interférerait pas avec le fonctionnement du résonateur.

Les moyens de découplage sont par exemple formés par une structure mécanique dont la fréquence de résonance est comprise entre la fréquence de résonance de l'accéléromètre et la fréquence de résonance du résonateur et avantageusement dont la fréquence de résonance est inférieure à 10 fois la fréquence du résonateur. Ainsi les efforts transmis entre le corps d'épreuve et le nanorésonateur sont à des fréquences inférieures à celle des moyens de découplage et ne sont pas susceptibles de réaliser un couplage provoquant un dysfonctionnement du capteur.

Par exemple les moyens de découplage comportent une masse suspendue, la masse étant reliée d'une part au résonateur et d'autre part au corps d'épreuve via un ressort. La masse et le ressort des moyens de découplage sont choisis pour présenter la fréquence de résonance adaptée.

L'un des objets de la présente demande est un capteur résonant comportant un support, un corps d'épreuve suspendu par rapport au support et présentant un fréquence de résonance ωa, des moyens de mesure d'une force comportant au moins un résonateur de fréquence de résonance $\omega_{rn}$, ladite force étant appliquée par le corps d'épreuve, et une structure de découplage mécanique interposée entre le corps d'épreuve et le résonateur, ladite structure de découplage comportant une masse de découplage, un premier élément de liaison entre la masse de découplage et le corps d'épreuve, un deuxième élément de liaison entre la masse de découplage et le résonateur, la structure de découplage présentant un mode de vibration principal dont la fréquence de résonance $\omega_d$ est telle que ωa <$\omega_d$< $\omega_{rn}$, ladite structure de découplage mécanique formant un filtre passe-bas mécanique entre le corps d'épreuve et le résonateur.

De préférence $\omega_d$ < $10 \times \omega_{rn}$.

Par exemple, le premier élément de liaison présente une raideur $k_{d1}$, le corps d'épreuve est suspendu au support par des moyens de suspension présentant une raideur $k_a$ et le rapport $k_a/k_{d1}$ est compris entre 1 et 100.

Dans un exemple de réalisation, le résonateur est directement ancré sur le corps d'épreuve et le premier élément de liaison comporte un ressort.

La masse de découplage peut avoir la forme d'une poutre qui est articulée en rotation par rapport au support autour d'une direction normale à un plan du capteur.

Par exemple, la masse de découplage est ancrée directement sur le support par une extrémité longitudinale.

Dans un autre exemple de réalisation, la structure de découplage comporte des moyens de suspension au support.

Selon une caractéristique additionnelle, le corps d'épreuve et la structure de découplage présentent une épaisseur d'une ou plusieurs dizaines de $\mu$m et le résonateur a une section de l'ordre de quelques centaines de nm de côté.

Le capteur résonant peut comporter des moyens pour modifier la raideur du premier élément de liaison, et/ou des moyens pour modifier la raideur du deuxième élément de liaison et/ou des moyens pour modifier la raideur des moyens de suspension de la structure de découplage au support.

Par exemple, le capteur résonant comporte au moins une première couche et une deuxième couche, la première couche présentant une épaisseur d'une ou plusieurs dizaines de $\mu$m et la deuxième couche présentant une épaisseur de quelques centaines de nm de côté. Le corps d'épreuve et la structure de découplage sont réalisés dans la première couche et la structure de découplage comporte une troisième couche en un matériau différent de celui de la première couche.

Avantageusement, le capteur résonant comporte deux résonateurs montés en différentielle, chaque résonateur étant relié au corps d'épreuve par une structure de découplage.

Le capteur résonant peut former, un accéléromètre résonant, dans lequel le corps d'épreuve est une masse sismique.

## BRÈVE DESCRIPTION DES DESSINS

La présente invention sera mieux comprise sur la base de la description qui va suivre et des dessins en annexe sur lesquels:

La figure 1 est une représentation schématique d'un accéléromètre résonance selon l'invention.
La figure 2 est une représentation du modèle mécanique de l'accéléromètre résonant de de la figure 1.

La figure 3 est une vue de dessus d'une réalisation pratique d'un accéléromètre selon la figure 1 mettant en oeuvre une mesure différentielle.

Les figures 4A à 4F sont des représentations schématiques de moyens de découplage selon d'autres exemples de réalisation.

La figure 5 est une représentation schématique d'un capteur résonant selon l'invention dans lequel le corps d'épreuve est mobile dans une direction hors-plan.

## EXPOSÉ DÉTAILLÉ DE MODES DE RÉALISATION PARTICULIERS

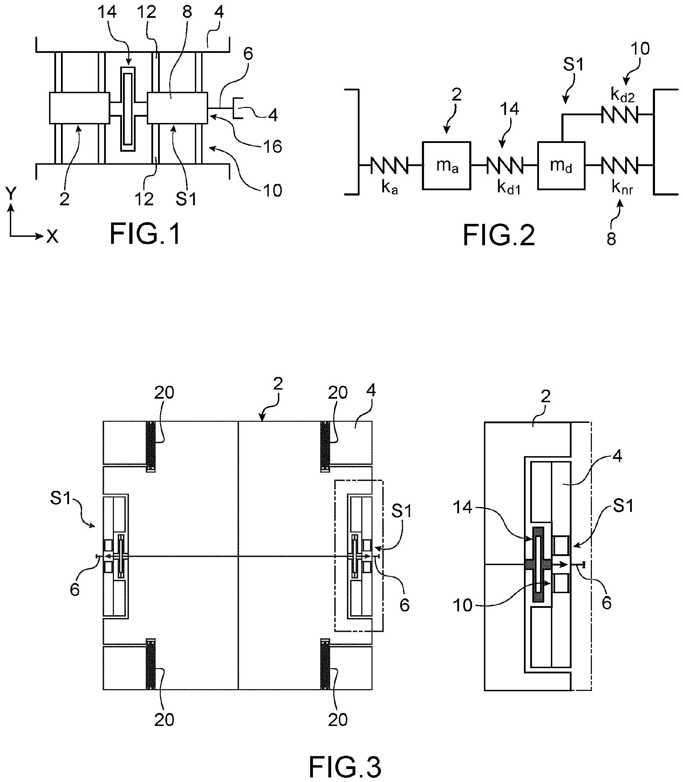

Sur la figure 1, on peut voir une représentation schématique d'un exemple d'accéléromètre selon l'invention comportant une masse sismique 2 suspendue à un support 4 ou substrat et mobile dans le plan du capteur par rapport au support. Le plan du capteur est considéré comme parallèle au support et forme un plan moyen pour la masse parallèle aux faces de plus grandes dimensions de la masse. Dans l'exemple représenté, la masse 2 est mobile le long de la direction X.

L'accéléromètre comporte un résonateur 6 formé par une poutre de section nanométrique, désigné par la suite nanorésonateur, qui a une section beaucoup plus petite que celle de la masse et les ressorts, idéalement une section de plus d'un ordre de grandeur plus petite que la section des ressorts. La section du nanorésonateur est par exemple comprise entre quelques dizaines de nm à 1 μm de côté, par exemple la section peut être comprise entre 25 nm × 25 nm et 2 μm × 2 μm. Le nanorésonateur est suspendu par une première extrémité longitudinale au support 4 et par une deuxième extrémité longitudinale à la masse sismique 2 via des moyens de découplage. Le nanorésonateur 6 s'étend le long de la direction X de sorte à être comprimé ou étiré lors du déplacement de la masse. La direction Y est contenue dans le plan et est orthogonale à la direction X.

Les moyens de découplage désignés par la suite "structure de découplage" S1 comprennent une masse de découplage 8 suspendue au support par des moyens de suspension 10. Dans l'exemple représenté les moyens de suspension 10 comportent deux paires de poutres 12 parallèles, les poutres 12 de chaque paire s'étendant de part et d'autre de la masse de découplage 8 par rapport à la direction X et le long de la direction Y. La masse de découplage 8 peut alors se déplacer selon la direction X, les poutres 12 se déformant en flexion.

Les moyens de découplage comportent également un premier élément de liaison 14 reliant la masse de découplage 8 à la masse sismique 2, et un deuxième élément de liaison 16 reliant la masse de découplage 8 et le nanorésonateur 6.

Dans cet exemple, le nanorésonateur 6 est directement ancré sur la masse de découplage 8 de la structure de découplage S1, le deuxième élément de liaison 16 peut donc être considéré comme rigide. Le premier élément de liaison 14 mis en oeuvre est tel qu'il est apte à se déformer élastiquement et remplit la fonction d'un ressort de transmission de force entre la masse sismique 2 et le nanorésonateur. Dans cet exemple, le premier élément de liaison 14 comporte un cadre 18 de forme rectangulaire, la masse sismique 2 étant reliée directement à un côté de grande longueur 18.1 et la masse de découplage 8 étant reliée à l'autre côté de grande longueur 18.2, les côtés de grande longueur étant capables de se déformer dans la direction X. Cet exemple de réalisation n'est pas exclusif d'autres formes qui seront décrites ci-dessous.

Sur la figure 2, on peut voir un modèle mécanique de l'accéléromètre de la figure 1.

La masse sismique 2 suspendue présente une masse, les moyens de suspension de la masse 2 sont modélisés par un ressort $R_a$ de raideur $k_a$ entre la masse 2 et le support. Le nanorésonateur est modélisé par un ressort $R_{nr}$ de raideur $k_{nr}$. La masse de découplage 8 a une masse $m_d$, les moyens de suspension de la masse de découplage 8 sont modélisés par un ressort $R_{d2}$ de raideur $k_{d2}$ entre la masse de découplage 8 et le support 4 et le premier élément de liaison 14 est modélisé par un ressort $R_{d1}$ de raideur $k_{d1}$ entre la masse de découplage 8 et la masse sismique 2.

La structure de découplage agit comme un résonateur et filtre les fréquences supérieures à sa fréquence de résonance $\omega_d$. A partir du modèle de la figure 2, nous pouvons calculer cette fréquence de résonance comme :

$$\omega_d^2 = \frac{k_{d2} + k_{d1} + k_{nr}}{m_d}$$

On choisit les caractéristiques de la structure de découplage de sorte qu'elle transmette les signaux à basse fréquence de l'accélération à mesurer et filtre effectivement les modes parasites dont les fréquences élevées peuvent se coupler avec le mode de résonance du nanorésonateur. Pour cela, la structure de découplage est réalisée telle que :

$$\omega_a <. \omega_{d.} < \omega_{nr}$$

Avec $\omega_a$ la fréquence propre de l'accéléromètre et $\omega_{nr}$ la fréquence propre du nanorésonateur.

De préférence, on choisit 10 $\omega_d < \omega_{nr}$.

Par ailleurs, la fonction de transfert de l'accéléromètre résonant est donnée par la relation entre l'accélération et la contrainte appliquée au nanorésonateur désigné $\sigma_{nr}$ et en considérant que la fréquence de résonance du nanorésonateur est proportionnelle à sa contrainte.

La fonction de transfert peut s'écrire :

$$\frac{\sigma_{nr}}{a} = \frac{m_a}{S_{nr}}\left[\frac{k_{nr}}{k_{nr} + k_{d2}}\right]\left[\frac{k_{d1}}{k_a + k_{d1}}\right]$$

Avec $S_{nr}$ est la section transversale du nanorésonateur.

Si on considère que les poutres 12 de la structure de découplage ont uniquement une fonction de stabilité, la raideur $k_{d2}$ de l'ensemble des poutres 12 est négligeable par rapport à la raideur $k_{nr}$ du nanorésonateur, la fonction de transfert peut être approximée à :

$$\frac{\sigma_{nr}}{a} \simeq \frac{m_a}{S_{nr}}\left[\frac{k_{d1}}{k_a + k_{d1}}\right]$$

On constate que la sensibilité de l'accéléromètre résonant est fixée par le rapport entre les raideurs $k_{d1}$ et $k_a$. De préférence, on choisit les valeurs de ces raideurs de sorte à ce que l'accéléromètre ait une sensibilité élevée. Le rapport $K_a/k_{d1}$ est avantageusement inférieur à 100 et de préférence égal à ou proche de 1.

La structure de couplage résonante peut présenter des modes de résonance autres que son mode de résonance principal à la fréquence $\omega_d$, qui peuvent interférer avec la gamme de fonctionnement du nanorésonateur et donc perturber le fonctionnement de l'accéléromètre. Le dimensionnement des différentes parties de la structure de découplage permet de fixer ces modes parasites de sorte qu'ils soient en dehors de la gamme de fréquence de fonctionnement du nanorésonateur.

À titre d'exemple uniquement, nous allons donner un dimensionnement de la structure de découplage et les valeurs de fréquence de résonance des modes parasites de celle-ci. La structure de découplage est celle de la figure 1.

La masse sismique 2 et ses moyens de suspension sont réalisés dans une couche de Si épaisse de 20 $\mu$m ; et le nanorésonateur est réalisé dans une couche plus fine de 0.25 $\mu$m d'épaisseur.

Les dimensions de la masse dans le plan peuvent être comprises entre 20$\mu$m$\times$20$\mu$m et 50$\mu$m$\times$50$\mu$m.

Le nanorésonateur a une section de 250 $\times$ 250 nm$^2$ et une longueur de 10 $\mu$m, qui présente une plage de fréquences du nanorésonateur de 10 MHz-20 MHz pendant son fonctionnement comme capteur.

La structure de découplage est réalisée dans la couche de silicium de 20 $\mu$m avec les dimensions suivantes :

La masse de découplage de forme carrée a des côtés de longueur $L_{m2}$ = 20 $\mu m$ et une masse $m_2$.

La longueur des poutres 12 est $L_{f2}$ = 20 $\mu m$ est la longueur des éléments, et leur largeur est égale à $w_{f2}$=1 $\mu$m.

Le premier élément de liaison 14 comporte deux bras de longueur $L_{c1}$ = 50 $\mu$m de largeur $w_{c1}$ = 1 $\mu m$, reliés par leurs extrémités par des masses carrée de côté de longueur $L_{mc1}$ = 5 $\mu m$ et de masse $m_{c1}$.

La fréquence de résonance de filtrage $\omega_d$ est de 1,7 MHz. La structure de découplage présente des fréquences parasites à 0,5 MHz et 22 MHz. Ces fréquences n'interfèrent pas avec la gamme de fonctionnement de 10 MHz - 20 MHz pour le nanorésonateur.

Sur la figure 3, on peut voir un exemple pratique d'un accéléromètre résonant mettant en oeuvre la structure de découplage S1.

L'accéléromètre comporte deux nanorésonateurs 6 montés en différentielle, chaque nanorésonateur étant relié à la masse sismique 2 par la structure de découplage S1. La masse sismique est suspendue au support par quatre ressorts 20 en forme de U. Ces quatre ressorts sont modélisés par le ressort de raideur $k_a$ dans le modèle de la figure 2.

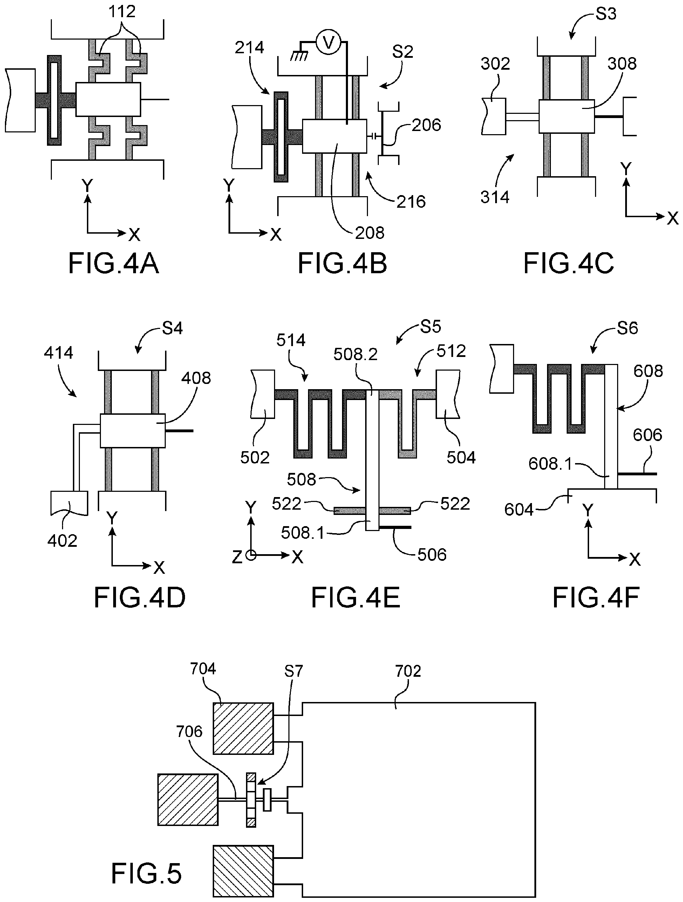

Dans l'exemple représenté, la masse de découplage 8 de la structure de découplage S1 est suspendue par quatre poutres 12. Selon un autre exemple représenté sur la figure 4A, la masse de découplage 108 est suspendue par des supports plus flexibles 112 que les poutres 12, par exemple en forme de U ou de Z. En outre plus ou moins de quatre supports peuvent être mis en oeuvre.

En variante encore, aucun support n'est mis en oeuvre et la masse de découplage 8 est suspendue par sa liaison à la masse de l'accéléromètre et par sa liaison au nanorésonateur.

En outre, dans un autre exemple de réalisation le nanorésonateur n'est pas ancré directement sur la masse de découplage, et le deuxième élément de liaison 16 entre la masse des moyens de découplage et le nanorésonateur peut présenter une certaine flexibilité et par exemple être similaire au premier élément de liaison 14 de la figure 1.

Sur la figure 4B, on peut voir un autre exemple de réalisation d'une structure de découplage S2, dans lequel la liaison 216 entre le nanorésonateur 206 et la structure de découplage n'est pas mécanique mais électrostatique. La structure de découplage et le nanorésonateur sont alors configurés pour présenter entre eux un couplage capacitif fort. Dans cet exemple, le nanorésonateur 206 est orienté orthogonalement à l'axe X et parallèlement et en regard d'une face de la masse de découplage 208. Ainsi en appliquant une différence de potentiel entre la masse 208 et le nanorésonateur 206, un couplage capacitif entre le nanorésonateur 206 et la face de la masse 208 est généré. Ce couplage assure la transmission de contrainte de la masse sismique 202 vers le nanorésonateur 206. En outre il permet de précontraindre le nanorésonateur. L'élément de liaison 214 entre la masse sismique 202 et la masse de découplage 28 peut être remplacé par une liaison électrostatique.

Selon un autre exemple de réalisation d'une structure de découplage S3 représenté sur la figure 4C, le premier élément de liaison 314 entre la masse de découplage 308 et la masse sismique 302 est formé par une poutre présentant une plus grande rigidité que le premier élément de liaison 14 de la figure 1. Néanmoins une telle poutre présente une certaine flexibilité qui est à prendre en compte dans la modélisation de la structure de découplage. Cet exemple présente l'avantage de réduire les pertes de signal par rapport à un élément de liaison plus flexible.

Dans un système MEMS&NEMS, par exemple un accéléromètre résonant, la masse sismique de l'accéléromètre est réalisée dans une couche de matériau épaisse, par exemple en silicium, par exemple d'une épaisseur de 20 μm et le nanorésonateur est réalisé dans une couche de matériau d'épaisseur beaucoup plus faible, par exemple en nitrure de silicium, par exemple d'une épaisseur de 0,25 μm. de préférence, la structure de découplage peut être réalisée dans la couche épaisse comme la masse sismique et présenter la même épaisseur. Une structure de découplage réalisée dans la couche d'épaisseur beaucoup plus faible ne sort pas du cadre de la présente invention, néanmoins elle peut présenter un nombre important de modes parasites à la fréquence du nanorésonateur.

De préférence, la masse sismique présente des dimensions dans le plan plus grande que celle de la structure de découplage permettant de limiter l'apparition de modes parasites des moyens de découplage dans la plage de fréquence du nanorésonateur. De préférence, la surface de la masse sismique est au moins 10 fois plus grande que celle de la structure de découplage.

En variante, la structure de découplage est réalisée dans la couche épaisse, elle est ensuite amincie et présente une épaisseur intermédiaire entre l'épaisseur de la masse sismique et celle du nanorésonateur. Ceci peut permettre d'offrir plus de liberté pour fixer la fréquence de résonance de la structure de découplage et d'augmenter la sensibilité du capteur par rapport à une structure non-amincie.

Dans un exemple de réalisation, la structure de découplage et la masse sismique peuvent être réalisées dans le même matériau, par exemple en silicium. Il peut être prévu de déposer une couche d'un matériau différent sur la structure de découplage permettant de modifier les propriétés mécaniques de la structure de découplage, par exemple les raideurs des éléments de liaison et de suspension.

Dans un autre exemple, la structure de découplage est réalisée dans un matériau différent de celui de la masse sismique ce qui permet, tout en conservant les mêmes dimensions de structure de découplage, une masse de découplage ayant une masse plus ou moins grande et/ou des éléments de liaison et/ou de suspension plus ou moins rigides. La réalisation de la structure de découplage dans un matériau différent peut par exemple comporter la gravure de la couche MEMS, le dépôt, par exemple par pulvérisation ("sputtering" en terminologie anglo-saxonne) d'un matériau sélectif sur la zone désirée de formation de la structure de découplage et ensuite le dépôt du matériau de la structure de découplage sur la zone désirée.

Dans un autre exemple, la structure de découplage est réalisée dans la couche dans laquelle le nanorésonateur est réalisé.

Cet exemple permet de réaliser des supports et un deuxième élément de liaison 16 plus flexibles du fait de leurs dimensions réduites. En outre, la masse de découplage 8 présente une masse réduite.

Ceci peut également permettre d'offrir plus de liberté pour fixer la fréquence de résonance de la structure de découplage.

Sur la figure 4D on peut voir un autre exemple de réalisation d'une structure de découplage S4, dans lequel le premier élément de liaison 414 entre la masse sismique 402 et la masse de découplage 408 comporte une poutre orientée le long de la direction Y, le long de laquelle est aligné le nanorésonateur 406, la poutre est encastrée par une extrémité à la masse sismique et par une autre extrémité à la masse de découplage 408. La poutre présente une flexibilité dans la direction X et est rigide dans la direction Y. Plus généralement, l'élément de liaison 414 est flexible dans une direction orthogonale à l'axe du nanorésonateur et rigide dans l'axe du nanorésonateur permettant une plus grande liberté dans l'arrangement relatif de la masse sismique et de la structure de découplage.

Sur la figure 4E, on peut voir un autre exemple de réalisation d'une structure de découplage S5, dans lequel la masse de découplage 508 comporte une poutre suspendue par rapport au support de sorte à être mobile en rotation dans le plan X-Y. Dans cet exemple, la masse de découplage 508 s'étend le long de la direction Y et le nanorésonateur 506 est ancré à une extrémité longitudinale 508.1 de la masse de découplage 508. La masse sismique 502 est reliée à l'autre extrémité longitudinale 508.2 de la masse de découplage 508 par un élément de liaison 514 en forme de serpentin. Deux poutres 522 alignées le long de la direction Y et ancrées sur la masse de découplage 508 à proximité de l'extrémité 508.1 forment une liaison pivot. Par exemple de moyens de suspension 512 en forme de serpentin suspendent la masse de découplage 508 au support 504 au niveau de l'extrémité 508.2. Dans cet exemple, la masse de découplage ne se déforme pas lors du fonctionnement de l'accéléromètre.

Sur la figure 4F, on peut voir un autre exemple de réalisation d'une structure de découplage S6 qui diffère de la structure S5 de la figure 4E, en ce que la masse de découplage 608 est directement ancrée au support 604 par son extrémité 608.1 et se déforme en flexion lors du fonctionnement de l'accéléromètre. Le nanorésonateur 606 est ancrée sur la poutre au niveau de son extrémité 608.1. Cet exemple permet de ne pas requérir de support 604 pour la masse de découplage 608, l'ancrage de celle-ci assurant son support.

Dans un exemple avantageux, la structure de découplage est telle qu'elle permet d'ajuster sa fréquence de résonance et éventuellement les modes parasites de la structure de découplage. La structure présente des moyens pour modifier la raideur du premier élément de liaison entre la masse de découplage et la masse sismique, et/ou la raideur du deuxième élément de liaison entre la masse de découplage et le nanorésonateur, et/ou la raideur du ou des moyens de suspension de la masse de découplage au support. Un tel ajustement de la structure de découplage permet de réaliser un capteur résonant présentant plusieurs plages de fonctionnement.

Par exemple les moyens d'ajustement de la raideur peuvent être du type piézoélectrique. Par exemple les éléments de liaison et/ou les éléments de suspension comportent une couche en matériau piézoélectrique, en choisissant l'intensité du courant électrique circulant dans cette couche on peut modifier la rigidité de ces éléments. La raideur de chaque élément peut être ajustée séparément. Cet ajustement peut être réalisé en usine, ce qui permet de réaliser une seule structure de capteur qui est ensuite adaptée à différentes applications, ou cet ajustement peut être fait lors du fonctionnement de l'accéléromètre en fonction de conditions extérieures. En variante, les moyens d'ajustement sont de manière non limitative de type thermique/thermoélectrique ou électrostatique.

La présente invention s'applique également à un capteur résonant dans lequel le corps d'épreuve 702 mobile dans une direction hors-plan par rapport au support 704 comme cela est schématisé sur la figure 5. La structure de découplage S7 est par exemple disposée entre le résonateur 706 et le corps d'épreuve 702.

Le capteur résonant selon l'invention est fabriqué avec les techniques de de fabrication des systèmes microélectromécaniques et nanoélectromécaniques ou M&NEMS (Micro&nanomicroelectromechanical systems).

Par exemple il peut être fabriqué en utilisant le procédé décrit dans le document WO201148138.

La présente invention est particulièrement adaptée à la réalisation d'accéléromètres résonants, permettant d'obtenir une gamme dynamique relativement élevée et une plage de fréquences relativement large.

L'invention peut s'appliquer à la réalisation d'autres capteurs résonants, tels que les capteurs de force résonants, comme par exemple les capteurs de pression, débitmètres, magnétomètres. L'invention est spécialement avantageuse dans le cas de capteurs avec une très large gamme dynamique, ce qui implique une plage de fréquences du nanorésonateur large, et en conséquence une forte probabilité d'avoir des modes parasites présents dans cette plage.

**Revendications**

1. Capteur résonant comportant un support (4), un corps d'épreuve (2) suspendu par rapport au support (4) et présentant une fréquence de résonance wa, des moyens de mesure d'une force comportant au moins un résonateur (6) de fréquence de résonance $\omega_{rn}$, ladite force étant appliquée par le corps d'épreuve (2), et une structure de découplage mécanique (S1) interposée entre le corps d'épreuve (2) et le résonateur (6), ladite structure de découplage (S1) comportant une masse de découplage (8), un premier élément de liaison (14) entre la masse de découplage (8) et le corps d'épreuve (2), un deuxième élément de liaison (16) entre la masse de découplage (8) et le résonateur (6), la structure de découplage (S1) présentant un mode de vibration principal dont la fréquence de résonance $\omega_d$ est telle que ωa $<\omega_d<$ $\omega_{rn}$, ladite structure de découplage mécanique (S1) formant un filtre passe-bas mécanique entre le corps d'épreuve (2) et le résonateur (6).

2. Capteur résonant selon la revendication 1, dans lequel $\omega_d < 10 \times \omega_m$.

3. Capteur résonant selon la revendication 1 ou 2, dans lequel le premier élément de liaison (14) présente une raideur $k_{d1}$, dans lequel le corps d'épreuve (2) est suspendu au support par des moyens de suspension présentant une raideur $k_a$ et dans lequel le rapport $k_a/k_{d1}$ est compris entre 1 et 100.

4. Capteur résonant selon l'une des revendications 1 à 3, dans lequel le résonateur (6) est directement ancré sur la masse de découplage (8) de ladite structure de découplage (S1) et le premier élément de liaison (14) comporte un ressort.

5. Capteur résonant selon l'une des revendications 1 à 4, dans lequel la masse de découplage a la forme d'une poutre qui est articulée en rotation par rapport au support autour d'une direction (Z) normale à un plan du capteur.

6. Capteur résonant selon la revendication 5, dans lequel la masse de découplage est ancrée directement sur le support par une extrémité longitudinale.

7. Capteur résonant selon l'une des revendications 1 à 4, dans lequel la structure de découplage comporte des moyens de suspension au support.

8. Capteur résonant selon l'une des revendications 1 à 7, dans lequel le corps d'épreuve et la structure de découplage présentent une épaisseur d'une ou plusieurs dizaines de $\mu$m et le résonateur a une section de l'ordre de quelques centaines de nm de côté.

9. Capteur résonant selon l'une des revendications 1 à 8, comportant des moyens pour modifier la raideur du premier élément de liaison, et/ou des moyens pour modifier la raideur du deuxième élément de liaison et/ou des moyens pour modifier la raideur des moyens de suspension de la structure de découplage au support.

10. Capteur résonant selon l'une des revendications 1 à 9, comportant au moins une première couche et une deuxième couche, la première couche présentant une épaisseur d'une ou plusieurs dizaines de $\mu$m et la deuxième couche présentant une épaisseur de quelques centaines de nm de côté, dans lequel le corps d'épreuve et la structure de découplage sont réalisés dans la première couche et dans lequel la structure de découplage comporte une troisième couche en un matériau différent de celui de la première couche.

11. Capteur résonant selon l'une des revendications 1 à 10, comportant deux résonateurs montés en différentielle, chaque résonateur étant relié au corps d'épreuve par une structure de découplage.

12. Capteur résonant selon l'une des revendications 1 à 11, formant un accéléromètre résonant, dans lequel le corps d'épreuve est une masse sismique.

**Patentansprüche**

1. Resonanzsensor, umfassend einen Träger (4), einen am Träger (4) aufgehängten Prüfkörper (2), der eine Resonanzfrequenz $\omega a$ aufweist, ein Mittel zum Messen einer Kraft, das mindestens einen Resonator mit der Resonanzfrequenz $\omega_{rn}$ umfasst, wobei die Kraft vom Prüfkörper (2) ausgeübt wird, und eine mechanische Entkopplungsstruktur (S1), die zwischen dem Prüfkörper (2) und dem Resonator (6) eingefügt ist, wobei die Entkopplungsstruktur (S1) eine Entkopplungsmasse (8), ein erstes Verbindungselement (14) zwischen der Entkopplungsmasse (8) und dem Prüfkörper (2), ein zweites Verbindungselement (16) zwischen der Entkopplungsmasse (8) und dem Resonator (6) umfasst, wobei die Entkopplungsstruktur (S1) einen Hauptschwingungsmodus aufweist, dessen Resonanzfrequenz $\omega_d$ so ist, dass $\omega a < \omega_d < \omega_{rn}$, wobei die mechanische Entkopplungsstruktur (S1) ein mechanisches Tiefpassfilter zwischen dem Prüfkörper (2) und dem Resonator (6) bildet.

2. Resonanzsensor nach Anspruch 1, wobei $\omega_d < 10 \times \omega_{rn}$.

3. Resonanzsensor nach Anspruch 1 oder 2, wobei das erste Verbindungselement (14) eine Steifigkeit $k_{d1}$ aufweist, wobei der Prüfkörper (2) durch Aufhängungsmittel mit einer Steifigkeit $k_a$ am Träger aufgehängt ist und wobei das Verhältnis $k_a/k_{d1}$ zwischen 1 und 100 liegt.

4. Resonanzsensor nach einem der Ansprüche 1 bis 3, wobei der Resonator (3) direkt an der Entkoppelungsmasse (8) der Entkoppelungsstruktur (S1) verankert ist und das erste Verbindungselement (14) eine Feder umfasst.

5. Resonanzsensor nach einem der Ansprüche 1 bis 4, wobei die Entkopplungsmasse die Form eines Balkens hat, der im Verhältnis zum Träger um eine Richtung (Z), die normal zu einer Ebene des Sensors verläuft, drehbar angelenkt ist.

6. Resonanzsensor nach Anspruch 5, wobei die Entkopplungsmasse über ein Längsende direkt am Träger verankert ist.

7. Resonanzsensor nach einem der Ansprüche 1 bis 4, wobei die Entkopplungsstruktur Mittel zum Aufhängen am Träger umfasst.

8. Resonanzsensor nach einem der Ansprüche 1 bis 7, wobei der Prüfkörper und die Entkopplungsstruktur eine Dicke von einem oder mehreren Dutzend $\mu$m aufweisen und der Resonator einen Abschnitt in der Größenordnung von einigen hundert nm hat.

9. Resonanzsensor nach einem der Ansprüche 1 bis 8, umfassend ein Mittel zum Modifizieren der Steifigkeit des ersten Verbindungselements und/oder ein Mittel zum Modifizieren der Steifigkeit des zweiten Verbindungselements und/oder ein Mittel zum Modifizieren der Steifigkeit der Aufhängungsmittel der Entkopplungsstruktur am Träger.

10. Resonanzsensor nach einem der Ansprüche 1 bis 9, umfassend mindestens eine erste Schicht und eine zweite Schicht, wobei die erste Schicht eine Dicke von einem oder mehreren Dutzend $\mu$m aufweist und die zweite Schicht auf jeder Seite eine Dicke von einigen hundert nm aufweist, wobei der Prüfkörper und die Entkopplungsstruktur in der ersten Schicht hergestellt sind und wobei die Entkopplungsstruktur eine dritte Schicht aus einem Material umfasst, das sich von dem der ersten Schicht unterscheidet.

11. Resonanzsensor nach einem der Ansprüche 1 bis 10, umfassend zwei unterschiedlich montierter Resonatoren, wobei jeder Resonator über eine Entkopplungsstruktur mit dem Prüfkörper verbunden ist.

12. Resonanzsensor nach einem der Ansprüche 1 bis 11, der einen Resonanzbeschleunigungsmesser bildet, wobei der Prüfkörper eine seismische Masse ist.

**Claims**

1. A resonant sensor including a support (4), a proof body (2) suspended from the support (4) and having a resonant frequency $\omega a$, means for measuring a force including at least one resonator (6) of resonant

frequency $\omega_m$, said force being applied by the proof body (2), and a mechanical decoupling structure (S1) interposed between the proof body and the resonator (6), said decoupling structure (S1) including a decoupling mass (8), a first connecting element (14) between the decoupling mass and the proof body, a second connecting element (16) between the decoupling mass (8) and the resonator (6), the decoupling structure (S1) having a main vibration mode whose resonant frequency $\omega_d$ is such that $\omega a < \omega_d < \omega_m$, said mechanical decoupling structure forming a mechanical lowpass filter between the proof body (2) and the resonator (6).

2. Resonant sensor according to claim 1, wherein $\omega_d < 10 \times \omega m$.

3. The resonant sensor according to claim 1 or 2, wherein the first connecting element (14) has a stiffness $k_{d1}$, wherein the proof body (2) is suspended from the support by suspension means having a stiffness $k_a$ and wherein the ratio $k_a/k_{d1}$ is between 1 and 100.

4. The resonant sensor according to any of the claims 1 to 3, wherein the resonator (6) is directly anchored to the proof body (8) of the decoupling structure (S1) and the first connecting element (S1) includes a spring.

5. The resonant sensor according to any of the claims 1 to 4, wherein the decoupling mass is in the form of a beam which is rotatably hinged relative to the support about a direction (Z) normal to a plane of the sensor.

6. The resonant sensor according to claim 5, wherein the decoupling mass is directly anchored to the support through a longitudinal end.

7. The resonant sensor according to any of the claims 1 to 4, wherein the decoupling structure includes means for suspending from the support.

8. The resonant sensor according to any of the claims 1 to 7, wherein the proof body and the decoupling structure have a thickness of one or more tens of $\mu$m and the resonator has a cross-section area in the order of a few hundred nm on each side.

9. The resonant sensor according to any of the claims 1 to 8, including means for modifying stiffness of the first connecting element, and/or means for modifying stiffness of the second connecting element and/or means for modifying stiffness of the means for suspending the decoupling structure from the support.

10. The resonant sensor according to any of the claims 1 to 9, comprising at least a first layer and a second layer, the first layer having a thickness of one or more tens of $\mu$m and the second layer having a thickness of a few hundred nm on each side, wherein the proof body and the decoupling structure are made in the first layer and wherein the decoupling structure includes a third layer of a material different from that of the first layer.

11. The resonant sensor according to any of the claims 1 to 10, including two differentially-mounted resonators, each resonator being connected to the proof body through a decoupling structure.

12. The resonant sensor according to any of the claims 1 to 11, forming a resonant accelerometer, wherein the proof body is a seismic mass.

FIG.1

FIG.2

FIG.3

FIG.4A

FIG.4B

FIG.4C

FIG.4D

FIG.4E

FIG.4F

FIG.5

## RÉFÉRENCES CITÉES DANS LA DESCRIPTION

**Documents brevets cités dans la description**

- US 2007163347 A
- WO 201148138 A